# FASCICULE DE BREVET EUROPEEN

(11) **EP 3 479 407 B1**
(45) Date de publication et mention de la délivrance du brevet: **01.09.2021**
(21) Numéro de dépôt: 17730215.5
(22) Date de dépôt: 20.06.2017
(51) Int. Cl.: H01L 27/146

(54) **CAPTEUR LINEAIRE POUR APPAREIL D'IMAGERIE DE TOMOGRAPHIE PAR COHERENCE OPTIQUE A SPECTROMETRE**
LINEARER SENSOR FÜR EINE SPEKTROSKOPISCHE OPTISCHE KOHÄRENZTOMOGRAPHISCHE BILDGEBUNGSVORRICHTUNG
LINEAR SENSOR FOR A SPECTROSCOPIC OPTICAL COHERENCE TOMOGRAPHY IMAGING APPARATUS

(30) Priorité: 30.06.2016 FR 1656158
(43) Date de publication de la demande: 08.05.2019
(73) Titulaire: Teledyne E2V Semiconductors SAS, 38120 Saint-Egrève (FR)
(72) Inventeur: LIGOZAT, Thierry, 38950 Quaix En Chartreuse (FR); GILI, Bruno, 73290 La Motte Servolex (FR); GUIGUET, Romain, 38000 Grenoble (FR); TELLIER, Franck, 38400 Saint Martin D'Heres (FR); MANGERET, Norman, 38360 St Etienne De Crossey (FR)
(74) Mandataire: Marks & Clerk France
(86) Numéro de dépôt international: PCT/EP2017/065069
(87) Numéro de publication internationale: WO 2018/001791

(56) Documents cités:
- DE-A1- 4 413 824
- US-A- 5 365 093
- US-A1- 2002 097 331

## Description

### DOMAINE TECHNIQUE

L'invention concerne une caméra à capteur linéaire utilisée dans les appareils d'imagerie de tomographie par cohérence optique à spectromètre.

L'imagerie de tomographie par cohérence optique dite imagerie OCT (de l'acronyme anglo-saxon), est une technique d'imagerie infrarouge sans contact et non invasive, qui permet une très haute résolution spatiale, avec une bonne sensibilité, et qui permet d'atteindre des profondeurs de tissus jusqu'à dix-douze millimètres environ. L'utilisation de cette technique d'imagerie s'est ainsi répandue en médecine conservatrice et de diagnostic, et notamment en ophtalmologie mais aussi en dermatologie pour aider à détecter et contrôler des modifications morphologiques architecturales des tissus. En ophtalmologie par exemple, l'OCT est devenu un outil indispensable pour le diagnostic et le suivi de pathologies rétiniennes, car il permet de visualiser de l'avant vers l'arrière les différentes couches constitutionnelles de la rétine.

La tomographie par cohérence optique dite OCT (acronyme anglais pour *Optical Coherence Tomography)* est basée sur l'interférométrie à faible longueur de cohérence. Elle utilise une source infrarouge à faible longueur de cohérence et il s'agit de mesurer le temps de parcours des ondes lumineuses réfléchies ou rétro-diffusées par les structures réfléchissantes ou rétro-diffusantes d'un objet à imager, pour déterminer leurs profondeurs. Le contraste de l'image obtenue par la technique OCT résulte de l'inhomogénéité d'indice de réfraction au sein de l'objet. On peut ainsi établir le profil de réflectivité (image 1D) d'un objet suivant la direction longitudinale ou axiale (profondeur z) pour chaque position transversale fixe x,y (point) de l'objet. En balayant différents points (x,y) de l'objet, on obtient différents profils (interférogrammes) et on peut reconstituer des images 2D, voire des images 3D.

La détection de signal pour la détermination des profondeurs peut avantageusement être faite directement dans le domaine fréquentiel, à partir du spectre en fréquence, et on parle alors de technique OCT spectralement résolue, ou d'OCT dans le domaine fréquentiel (OCT-FD). L'imagerie OCT dans le domaine fréquentiel s'est beaucoup développée car elle permet un gain en vitesse d'acquisition par rapport aux systèmes utilisant une détection dans le domaine temporel. Elle offre également un meilleur rapport signal sur bruit.

Il existe différentes techniques de détection dans le domaine fréquentiel, en fonction du type de sources de lumière utilisée, mais celle qui nous intéresse plus particulièrement dans l'invention, est celle qui est basée sur une source infrarouge à large spectre et à faible longueur de cohérence et qui utilise un spectromètre intégrant une caméra à capteur linéaire. Pour chaque point de l'objet à imager, le spectromètre placé à la sortie de l'interféromètre génère une image de franges d'interférence, et cette image est formée dans le plan du capteur linéaire de la caméra : le capteur capture cette image spectrale et fournit en sortie la mesure d'intensité des franges d'interférence.

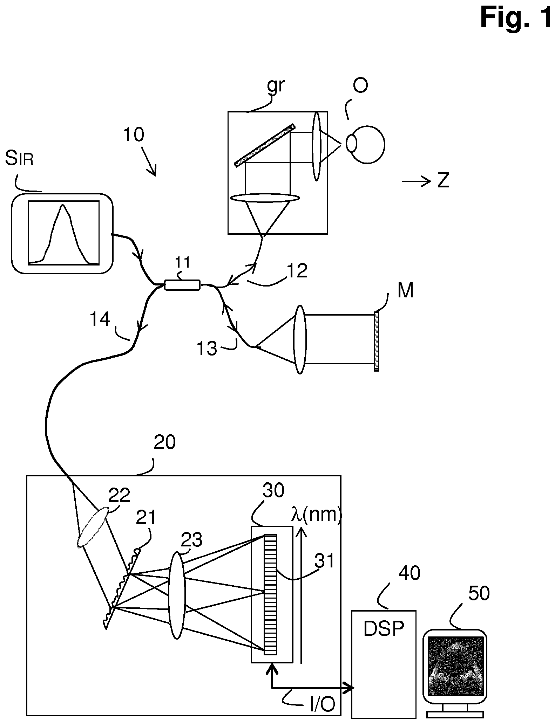

Les éléments de base d'un appareil OCT de ce type sont schématiquement représentés sur la figure 1.

On a donc un interféromètre de type Michelson, 10, généralement à fibres optiques. L'interféromètre est éclairé par une source de lumière infrarouge large bande à faible longueur de cohérence SIR. La lumière reçue de la source est séparée en deux parties (séparateur/coupleur optique 11) : l'une est envoyée dans le bras de référence 13 de l'interféromètre pour éclairer la surface d'un miroir de référence M (fixe) ; l'autre est envoyé dans le bras d'échantillon 12 de l'interféromètre pour éclairer un point de l'objet O à imager. La lumière réfléchie ou rétro-diffusée par les deux bras 12 et 13 arrive dans le bras de sortie 14 : des interférences se produisent à condition que la différence de longueur optique des deux bras soit inférieure à la longueur de cohérence de la lumière.

Un spectromètre 20 comprend un élément dispersif 21, par exemple un réseau de diffraction associé à des éléments d'optique (lentilles), qui disperse le spectre de lumière reçue du bras de sortie de l'interféromètre en fonction de la longueur d'onde et dirige sélectivement les différentes régions spectrales vers les différents pixels d'une ligne de détection photosensible (capteur linéaire 31) d'une caméra 30. La caméra intègre le capteur linéaire 31 et les éléments d'optique nécessaires.

Le capteur linéaire 31 comprend une ligne de pixels photosensibles, par exemple 1024 pixels ou 2048 pixels, et la circuiterie de séquencement de prise d'image et de lecture des pixels. Il permet de capturer, pour un point de l'objet à imager, une image spectrale qui est étalée sur toute la longueur de la ligne de pixels, et on a une correspondance établie, pour le spectromètre considéré, entre les positions des pixels et les longueurs d'onde de la bande spectrale de la source SIR. Chaque pixel permet de mesurer l'intensité lumineuse pour une longueur d'onde déterminée du spectre. C'est ainsi que les signaux de sortie des pixels permettent d'établir directement la courbe d'intensité lumineuse en fonction de la longueur d'onde pour chaque point de l'objet. Ces données sont transmises à un circuit de traitement de données (calculateur) pour les traiter et afficher les images tomographiques de l'objet.

A chaque prise d'image par la caméra à capteur linéaire, les signaux de sortie des pixels sont transmis à un système de traitement numérique 40 (calculateur) qui connait la correspondance entre la position du pixel dans la ligne du capteur linéaire, et la longueur d'onde (courbe d'étalonnage du spectromètre), pour appliquer différents algorithmes dont une transformée de Fourier du spectre et fournir le profil 1D en profondeur sous le point observé. En balayant le faisceau lumineux sur l'objet, on construit par calcul l'image tomographique en 2 ou 3 dimensions à partir des différents profils 1D obtenus. Des capteurs linéaires sont divulgués par US5365093A, DE4413824A1 et US2002/097331A1 de l'art antérieur.

### PRESENTATION DU PROBLEME TECHNIQUE

L'image de décomposition spectrale par le réseau de diffraction est projetée dans le plan photosensible du capteur linéaire, et se présente dans ce plan comme une ligne lumineuse (un trait lumineux) ayant une certaine largeur (épaisseur du trait), sur toute la longueur du capteur.

Comme on veut obtenir une information la plus précise pour chaque longueur d'onde de la bande spectrale de la source lumineuse de l'appareil OCT, la hauteur des pixels doit au moins correspondre à la largeur de la ligne lumineuse, c'est-à-dire à la taille de l'information lumineuse à capturer ; et il faut que la ligne lumineuse projetée soit bien centrée et alignée sur la ligne de pixels : si ce n'est pas le cas, une partie de la ligne lumineuse se trouve hors du cadre photosensible de la ligne de pixels, et on perd l'information correspondante.

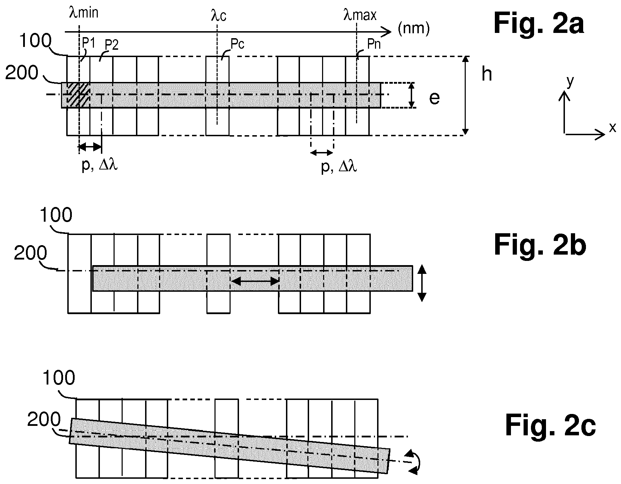

Les figures 2a à 2c illustrent cette problématique d'alignement de la ligne lumineuse 200, grisée sur la figure, projetée sur la ligne photosensible 100 d'un capteur linéaire 31. La ligne 100 comprend n pixels P1 à Pn et s'étend horizontalement dans le plan de la feuille.

Pour réduire les contraintes de précision de l'alignement, les capteurs linéaires utilisés en imagerie OCT utilisent généralement des pixels dont la hauteur de surface photosensible est plus grande que la taille de l'information lumineuse à capturer, par exemple au moins deux fois plus grande et jusqu'à 10 ou 20 fois plus grande : on peut regarder l'ensemble des surfaces photosensible des pixels de la ligne comme un cadre à l'intérieur duquel la ligne d'image doit être projetée. Plus le cadre est grand en hauteur, plus il est facile de cadrer la ligne lumineuse.

Sur les figures 2a à 2c les pixels sont figurés par un simple rectangle plus haut que large, qui représente la surface photosensible du pixel, qui est l'essentiel de la surface de pixel. C'est-à-dire que l'on ignore les éventuels éléments de commande ou de connexion des pixels disposés entre ces zones photosensibles. L'écart de centre à centre des pixels est le pas (ou "pitch") p du capteur, qui correspond sensiblement à la largeur (de surface photosensible) des pixels (en ignorant les éventuels éléments de commande ou de connexion des pixels).

L'image spectrale à détecter, matérialisée sur la figure 2a par la ligne grisée 200, est dans l'exemple, une ligne lumineuse en forme d'un trait rectiligne, qui s'étend sur toute la longueur de la ligne de pixels, et cette ligne lumineuse a une largeur e (dans le sens de la hauteur du pixel) faible devant la hauteur h de la surface rectangle photosensible des pixels. Le rapport h/e peut être compris entre 2 et 20, mais cela n'est pas limitatif. Dans un exemple numérique donné à titre d'exemple non limitatif, la ligne lumineuse peut avoir une largeur de 20 micromètres ; et le pas et la hauteur des pixels peuvent être respectivement de 10 et 60 micromètres.

La figure 2a montre le cas d'un alignement correct de la ligne lumineuse 200 sur la ligne photosensible de pixels 100 : la ligne lumineuse 200 est bien centrée par rapport au cadre de surface photosensible de la ligne de pixels 100, tant en hauteur qu'en largeur. Chaque pixel peut détecter le maximum d'information lumineuse. Plus précisément :
- elle est centrée sur la ligne 100 de pixels du capteur dans le sens de la hauteur ; c'est-à-dire que l'axe de symétrie horizontale de la ligne d'image est sensiblement confondu avec l'axe de symétrie horizontale de la ligne de pixel.
- elle est aussi centrée sur la ligne 100 de pixels du capteur relativement à la longueur de la ligne de pixels.

Dans ce cas, si la bande spectrale d'intérêt de la source lumineuse de l'appareil OCT est 840 nm +/- 50 nm, le pixel central Pc, va voir toute l'information correspondant à la longueur d'onde centrale λc de la bande spectrale à détecter, par exemple 840 nm ; le premier pixel P₁ à une extrémité de la ligne de pixels, va voir toute l'information lumineuse correspondant à la longueur d'onde minimale λmin de la bande spectrale à détecter, dans l'exemple 790 nm (λc - 50 nm) ; le dernier pixel P_{N} à l'autre extrémité de la ligne de pixels, va voir toute l'information lumineuse correspondant à la longueur d'onde maximale λmax de la bande spectrale à détecter, dans l'exemple 890 nm (λc + 50 nm).

Les figures 2b et 2c montrent en exemple deux situations possibles de désalignement. Dans le premier cas (Fig.2b), la ligne d'image est parallèle à la ligne de pixel mais décalée en x et en y ; dans le second cas (Fig.2c), la ligne d'image présente un angle avec l'axe de la ligne de pixels (Fig.2d) et est également décalée en y.

En pratique on peut rencontrer toutes les situations de désalignement possibles : désalignement en x et/ou y et /ou désalignement angulaire. Et ces désalignements s'accompagnent de plus ou moins de perte d'information. Notamment toute l'information lumineuse qui est en dehors du cadre de la zone photosensible des pixels qui permet de détecter un rayonnement lumineux est perdue ; et l'information lumineuse vue par un pixel peut correspondre à une longueur d'onde qui n'est pas celle correspondant à l'étalonnage.

Il apparait donc qu'en imagerie OCT, l'alignement de la ligne lumineuse sur la ligne de pixels est une opération cruciale, car l'exploitation des images aux fins de diagnostics ou de suivi médical dépend de la qualité et de la précision des images tomographiques obtenues.

En pratique, c'est l'intégrateur de l'appareil, c'est-à-dire celui qui réalise la production de l'appareil, ou l'opérateur qui en assure la maintenance sur site, qui réalise cette opération, en utilisant des appareils de contrôle optique complexes, pour régler de manière fine la position et l'orientation des éléments du spectromètre de l'appareil OCT les uns par rapport aux autres, c'est-à-dire sur l'élément dispersif et/ou sur la caméra intégrant le capteur linéaire. Des repères optiques (croix) disposés à chaque extrémité de la ligne de pixels, peuvent être utilisés pour cette opération.

Ce problème d'alignement se pose aussi bien à l'intégration de l'appareil qu'au cours de son utilisation, car les réglages de position et d'orientation des éléments du spectromètre sont sensibles aux conditions d'utilisation, qu'il s'agisse de déplacements, pouvant occasionner des vibrations, ou de changements de température.

### RESUME DE L'INVENTION

L'invention a pour objet de proposer une aide à l'alignement d'une ligne d'image sur une ligne photosensible d'un capteur linéaire, par une information d'alignement fournie par le capteur lui-même. L'idée à la base de l'invention est l'obtention à partir des signaux de sortie du capteur d'une information précise représentative de l'alignement d'une ligne d'image par rapport à la ligne de pixels du capteur. On peut alors corriger/réaliser l'alignement sur la base de cette information, en utilisant les techniques habituelles de réglage prévues dans le spectromètre ou l'appareil OCT (position et d'orientation du réseau de diffraction et/ou du capteur linéaire). L'invention est utilisable au moment de l'intégration des éléments de l'appareil OCT et aussi tout au long de la vie de l'appareil.

Plus précisément, l'invention utilise le fait, vérifié en pratique, que l'écart entre les longueurs d'onde vues par deux pixels adjacents est tellement faible que l'on peut considérer qu'ils vont fournir la même réponse en sortie. Dans l'exemple donné supra d'une source SIR à 840 nm +/- 50 nm, et d'une ligne de 2048 pixels, l'écart Δλ en longueur d'onde entre deux pixels adjacents est inférieur à 0,1 nanomètre (0,1.10⁻⁹ m).

L'idée de l'invention c'est de modifier la partie photosensible de deux pixels adjacents de manière à ce qu'ils fournissent le même signal de sortie en réponse lorsque la ligne d'image est effectivement centrée ; et fournissent une réponse qui varie de manière opposée pour les deux pixels, en cas de désalignement : le signe de la différence entre les deux signaux de réponse permet directement de savoir si la ligne d'image à l'endroit des pixels est décentrée vers le bas ou vers le haut ; la valeur de la différence permet de déterminer plus précisément de combien elle est décentrée en ce point.

Si on prévoit une telle paire de pixels de détection en deux endroits différents de la ligne de pixels, les signaux de sortie de ces pixels permettent de déterminer précisément comment est positionnée la ligne d'image par rapport à la ligne de pixels et déterminer les corrections à apporter sur la position et l'orientation des éléments du spectromètre.

Telle que caractérisée, l'invention concerne un capteur linéaire selon la revendication 1.

Par " surface photosensible utile" d'un pixel on entend la surface du pixel qui peut effectivement recevoir des photons et les transformer en charges électriques pouvant être accumulées en vue d'une mesure d'éclairement. Chaque pixel comporte en effet un matériau photosensible qui peut accumuler des charges photogénérées et qui s'étend sur une surface donnée qu'on peut appeler "surface photosensible". Cette surface photosensible est de préférence rectangulaire. Si cette surface reçoit effectivement de la lumière, elle produira et accumulera des charges électriques en proportion de la lumière reçue ; si elle est partiellement masquée par un masque opaque appelé masque optique, seule la surface non masquée constitue une "surface photosensible utile", c'est-à-dire une surface qui permet de détecter un rayonnement lumineux, puisque la surface masquée ne peut pas engendrer de charges électriques.

Dans une réalisation, la constitution physique des pixels est identique pour tous les N pixels, et un masque optique différencie les pixels de prise d'image des pixels de détection d'alignement. Dans cette réalisation, tous les pixels ont une surface photosensible rectangulaire, et le masque optique définit une surface photosensible utile non rectangulaire pour les pixels de détection d'alignement. Le masque optique peut aussi définir, pour les pixels de prise d'image, une surface photosensible utile rectangulaire plus petite (en pratique moins haute) que la surface photosensible rectangulaire des pixels.

Dans une autre réalisation, la forme des parties de surface photosensible des pixels de détection est délimitée par implantation. Dans cette réalisation, il n'y a pas de masque optique pour délimiter la surface utile des pixels de détection d'alignement, et il y a coïncidence entre la "surface photosensible" et la "surface photosensible utile" de ces pixels.

L'invention concerne également une caméra pour être utilisée dans un spectromètre d'un appareil d'imagerie de tomographie par cohérence optique dans le domaine de Fourier, qui comporte un capteur linéaire selon l'invention fournissant une information d'alignement d'une image spectrale formée par le spectromètre dans le plan de surface photosensible du capteur, sur la ligne de pixels de prise d'image du capteur.

D'autres caractéristiques et avantages de l'invention sont présentés dans la description suivante, en référence aux dessins annexés dans lesquels :
- la figure 1 déjà décrite illustre la constitution d'un appareil OCT à spectromètre à détection dans le domaine de Fourier;
- les figures 2a, 2b et 2c illustrent la problématique de l'alignement de la source d'image lumineuse par rapport au capteur linéaire de la caméra du spectromètre de l'appareil OCT ;
- la figure 3 illustre le principe d'une détection d'alignement basée sur une paire de pixels de détection selon l'invention ;
- la figure 4 illustre une ligne photosensible d'un capteur linéaire comprenant deux paires de pixels de détection, une à chaque extrémité de la ligne, et un premier mode de réalisation des pixels de détection ;
- la figure 5 illustre un deuxième mode de réalisation des pixels de détection de la ligne de la figure 4 ;
- les figures 6 et 7 illustrent une ligne photosensible d'un capteur linéaire comprenant en plus des deux paires de pixels de détection à chaque extrémité de ligne, une paire supplémentaire de pixels de détection disposée aux alentours du milieu de la ligne, dans deux exemples de réalisation des pixels de détection de la paire médiane ; et
- la figure 8 illustre un exemple de réalisation d'une ligne photosensible telle qu'illustrée sur les figures 5, 6 ou 7, utilisant un masque optique pour délimiter les parties photosensibles des pixels de détection.

### DESCRIPTION DETAILLEE

La ligne de pixels de prise d'image d'un capteur linéaire selon l'invention comprend parmi les N pixels de la ligne au moins deux paires de pixels adjacents, dont les signaux de sortie sont utilisés pour une détection d'alignement. Les pixels de détection sont tels que la surface photosensible utile du pixel, c'est-à-dire la partie de surface photosensible du pixel qui permet de détecter un rayonnement lumineux, a une largeur qui varie de façon monotone dans le sens de la hauteur, mais en sens contraire dans les deux pixels d'une même paire.

Les deux pixels de chaque paire présentent ainsi par construction, une dissymétrie de réponse sur la hauteur du pixel. Cette dissymétrie de réponse permet de déterminer avec précision la hauteur de la ligne d'image au niveau de la paire de pixels. Les pixels de prise d'image ont au contraire une surface photosensible utile dont la largeur est constante.

On peut généralement assimiler la ligne d'image projetée par le spectromètre dans le plan de surface photosensible du capteur linéaire à un trait lumineux rectiligne : deux paires de pixels de détection selon l'invention, de préférence une paire à chaque extrémité de la ligne, fournissent deux informations, en deux "points d'intérêt" de la ligne de pixels, permettant de déterminer précisément la position du trait de ligne d'image. Un point d'intérêt correspond à une paire de pixels de détection ; et la détection permet de dire si au point d'intérêt, la ligne d'image passe au centre, au dessus, ou en dessous.

Dans certains spectromètres, la ligne d'image projetée a plutôt une forme de demi-sinusoïde avec une amplitude maximale en crête ou creux sensiblement dans le milieu de la ligne de pixels. On prévoit de préférence dans ce cas au moins une troisième paire de pixels de détection, définissant un troisième point d'intérêt dans la ligne de pixel aux alentours du milieu de la ligne de pixels. La combinaison des informations fournies par les paires de détection prévues aux extrémités et au voisinage du milieu permet de vérifier que la ligne d'image ne sort pas du cadre de la ligne de pixels : l'axe passant par les centres des pixels de la ligne doit correspondre à une médiatrice de la forme de ligne d'image.

En pratique, pour pouvoir faire la détection d'alignement, on pourra utiliser le flux lumineux émis directement par la source lumineuse de l'appareil OCT, en entrée du spectromètre, (ou placer un miroir à la place de l'objet à imager) en sorte que l'image projetée par le spectromètre dans le plan de surface photosensible du capteur a une information lumineuse non nulle sur l'ensemble de la bande spectrale de la source. Notamment, on a bien une information lumineuse de puissance déterminée non nulle à la longueur d'onde de chacun des pixels de détection des paires de détection d'alignement prévues dans la ligne de prise d'image.

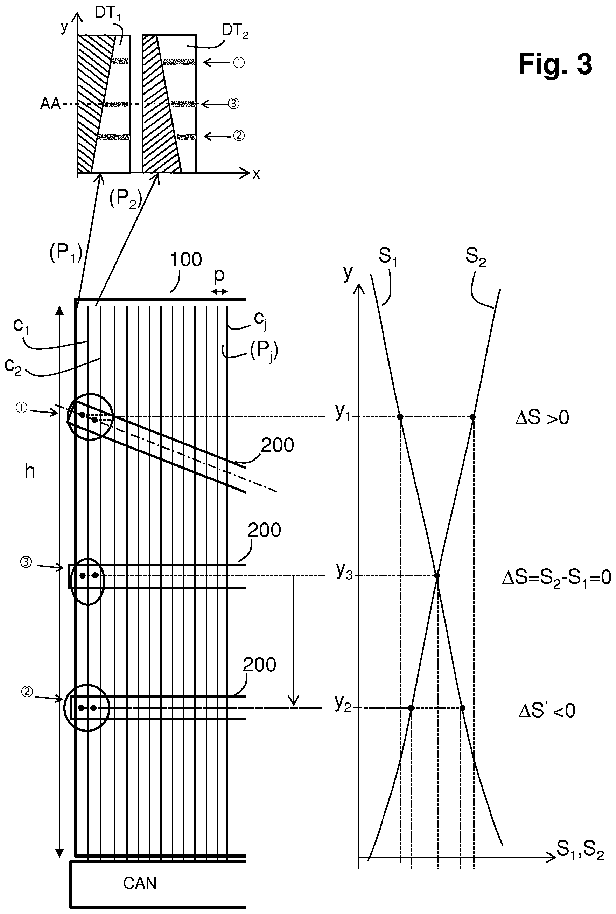

Les pixels de détection sont lus comme tous les autres pixels de la ligne, par le circuit de lecture des pixels (CAN, Figure 3) qui transmet les signaux de sortie obtenus au calculateur de traitement d'image (Figure 1). Ce dernier peut facilement traiter les signaux fournis par les pixels de détection de chaque paire, c'est-à-dire calculer la différence entre les deux signaux de chaque paire, pour déterminer précisément la position de la ligne d'image, et les corrections éventuelles à y apporter.

La figure 3 illustre le principe de l'invention avec une vue de dessus des premiers pixels P₁, P₂, ....Pⱼ d'une ligne photosensible 100 du capteur linéaire ; une vue agrandie d'une constitution possible des deux premiers pixels P₁ et P₂ qui forment une paire de pixels de détection selon l'invention; et la courbe de réponse de ces deux pixels selon la hauteur de l'information capturée par eux.

Le capteur linéaire est de constitution classique, en technologie CCD ou CMOS, bien connue de l'homme de l'art.

Les pixels, de structure identique, ont un aspect filiforme, c'est-à-dire qu'ils ont une forme essentiellement rectangle (aux tolérances de fabrication près), plus haute que large, dans un rapport qui peut aller jusqu'à 10 ou 20 par exemple. On parle ici de la forme de l'élément photosensible du pixel, vue dans le plan de surface du substrat semi-conducteur dans lequel le capteur est réalisé.

On a déjà expliqué que la structure de pixel peut comprendre en plus de l'élément photosensible, d'autres éléments de commande ou de connexion, et que l'on peut donc avoir des éléments de commande ou de connexion d'un pixel placés entre l'élément photosensible du pixel et l'élément photosensible du pixel suivant dans la ligne. Dans l'exemple de la figure 3, on a par exemple figuré pour chaque pixel P₁, P₂, ....Pⱼ, de la ligne, un élément conducteur correspondant c₁, c₂, ....cⱼ, disposé en colonne, et qui sert à acheminer les charges accumulées dans l'élément photosensible du pixel auquel il est relié vers un étage respectif d'un circuit de lecture CAN (conversion analogique numérique) disposé en pied de colonne. C'est le circuit de lecture du capteur qui fournit les signaux (numériques) de sortie des pixels. Dans le contexte d'un capteur linéaire intégré au spectromètre d'un appareil d'imagerie OCT, on a expliqué que deux pixels adjacents, dont les centres sont distants du pas p de la ligne de pixels, voient la même information lumineuse. C'est-à-dire qu'ils ne sont pas sensibles à l'écart Δλ de longueur d'onde entre les deux pixels (au premier ordre). En assurant par conception une réponse dissymétrique relativement à la hauteur de deux pixels adjacents, on peut déterminer si l'information lumineuse vue par les deux pixels, dont la taille est petite devant la hauteur de la partie photosensible du pixel, est centrée à l'endroit des deux pixels, ou décentrée vers le haut ou vers le bas. Si en pratique les deux pixels voisins ne voyaient pas exactement la même information lumineuse, on saura déterminer le petit écart de réponse entre les deux pixels au moment de la calibration du capteur, pour tenir compte de cet écart pour l'analyse du signal lors de l'alignement.

Dans l'exemple illustré sur la figure 3, les deux pixels P₁ et P₂ de la ligne de pixels 100 forment une paire de détection d'alignement selon l'invention : les parties permettant la détection d'une information lumineuse dans ces pixels sont les parties référencées respectivement DT₁ pour le pixel P₁ et DT₂ pour le pixel P₂. La partie DT₁ du pixel P₁ est plus large en bas (ordonnée 0) qu'en haut (ordonnée H) et la courbe de réponse S₁ est monotone décroissante suivant la hauteur. Pour le pixel P₂ c'est l'inverse.

La situation ① illustrée sur la figure 3 montre le cas d'une ligne d'image qui au niveau des pixels P₁ et P₂, est décentrée vers le haut de la ligne de pixels : le pixel P₁ va répondre moins que le pixel P₂ et le signal de sortie S₁ sera petit devant le signal de sortie S₂. La ligne d'image montre également une inclinaison, exagérée sur la figure. En réalité compte-tenu du rapport entre la hauteur h de la fenêtre de détection et la longueur de ligne (généralement plus de 1000 ou 2000 pixels) les deux pixels adjacents perçoivent l'information à sensiblement la même hauteur repérée sur la courbe par l'ordonnée y₁.

La situation ② est la situation inverse : la ligne d'image est décentrée vers le bas, à une hauteur repérée sur la courbe par l'ordonnée y₂ : le pixel P₁ va répondre plus que le pixel P₂ et le signal de sortie S₁ sera grand devant le signal de sortie S₂.

La situation ③ est celle d'une ligne d'image centrée : les pixels P₁ et P₂ donnent la même réponse, correspondant à une hauteur de ligne d'image repérée par l'ordonnée y₃, qui correspond à la hauteur de l'axe central de la ligne de pixels (passant par les centres des pixels).

Le signe de la différence ΔS=S₂-S₁ entre les deux signaux de sortie des pixels P₁ et P₂ permet directement de savoir comment se situe la ligne d'image à cet endroit, par rapport au centre des pixels P₁ et P₂.

Si on connait la courbe de réponse des pixels, pour une puissance lumineuse donnée (courbe d'étalonnage), on peut également déterminer à partir de la différence de signal ΔS=S₂-S₁, la hauteur de l'image au point d'intérêt.

Les signaux de sortie des pixels de détection P₁ et P₂ permettent donc d'obtenir une information de position de la ligne d'image en un point d'intérêt de la ligne de pixels du capteur.

On a ici considéré que les deux pixels P₁ et P₂ fournissent une même valeur de signal de sortie (S₁=S₂) pour une même information lumineuse (longueur d'onde, puissance). En pratique, les réponses des deux pixels peuvent ne pas être strictement égales, mais ces réponses seront déterministes pour un appareil OCT et une source SIR donnés. C'est à dire que l'on peut étalonner le capteur conçu selon l'invention, en fonction des caractéristiques de la source lumineuse de l'appareil OCT et des caractéristiques de dispersion spectrales du spectromètre. En d'autres termes, pour un appareil OCT donné, on pourra fournir des courbes d'étalonnage des signaux de sortie de chacune des paires de détection.

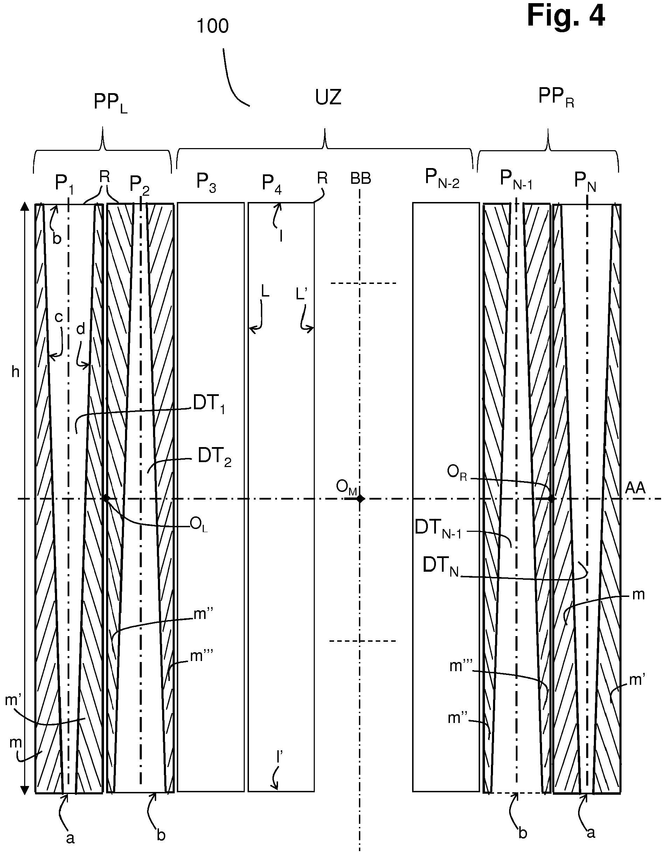

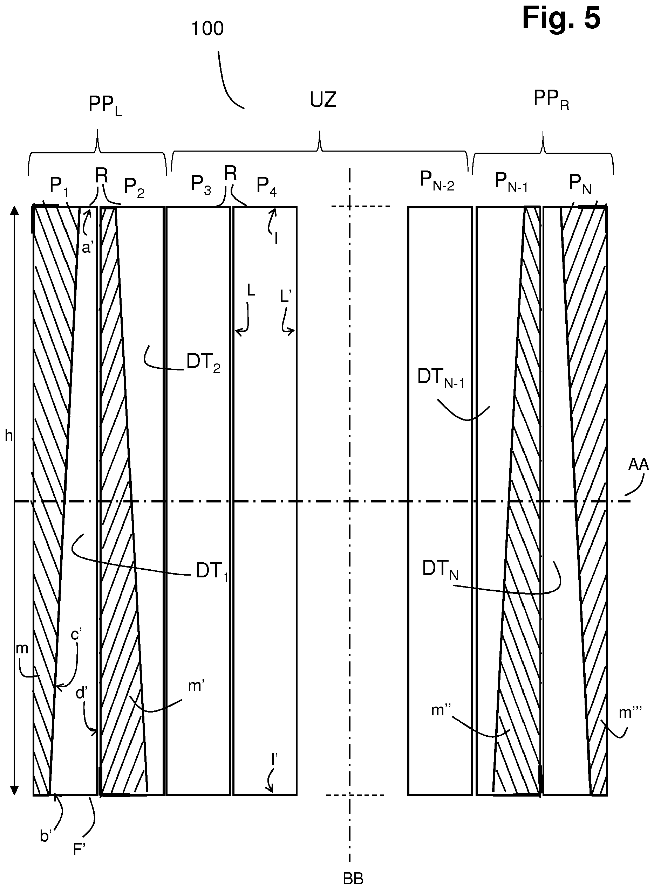

Les figures 4 et 5 représentent un exemple de réalisation d'une ligne 100 de N pixels P₁ à P_{N} comportant deux paires de pixels de détection selon l'invention fournissant deux informations de position, en deux points d'intérêt différents de la ligne de pixels. De préférence, et comme représenté sur les figures, les deux paires sont chacune à une extrémité de la ligne : la paire PP_{L} est formée par les deux premiers pixels adjacents de la ligne, P₁ et P₂ ; la paire PP_{R} est formée par les deux derniers pixels adjacents de la ligne, P_{N-1} et P_{N}. Dans ces figures, l'axe AA est l'axe central de la ligne de pixels, qui passe par tous les centres des pixels de la ligne. Comme on a pu l'expliquer précédemment, en considérant une ligne d'image en forme de trait sensiblement rectiligne, chaque paire donne une information de position de la ligne d'image ; et les deux paires permettent donc d'avoir la position de la ligne d'image en deux points d'intérêt de la ligne de pixels par rapport à l'axe AA : à savoir si la ligne d'image est centrée sur la ligne de pixels ; ou si elle est dans l'axe de la ligne de pixels mais décalée vers le haut, ou vers le bas ; ou encore si elle est inclinée par rapport à l'axe de la ligne de pixels, et dans quel sens.

Dans ces deux figures, tous les pixels de la ligne sont identiques au niveau de leur structure semi-conductrice. En particulier l'élément photosensible de tous ces pixels, qui est généralement une photodiode, a une surface photosensible, dans le plan de surface du substrat semi-conducteur, qui a la même forme rectangle R, plus haute (hauteur h) que large.

Un niveau de masque optique réalisé au-dessus du plan de surface photosensible permet alors de définir (délimiter) la surface photosensible utile (DT₁, DT₂, DT_{N-1} et DT_{N}) des pixels de détection (P₁, P₂, P_{N-1} et P_{N}) qui permet la détection d'un rayonnement lumineux selon l'invention. De préférence et comme illustré, la figure de la surface photosensible utile des pixels de détection est identique pour tous les pixels de détection, mais elle est disposée en sens inverse pour les deux pixels d'une même paire.

Dans l'exemple de la figure 4, la surface photosensible utile des pixels de détection a une forme F identique pour tous les pixels de détection, comprise dans la forme de rectangle R, s'étendant sur toute la hauteur du rectangle entre les petits côtés l et l' de la forme rectangle R et qui présente une symétrie axiale par rapport à la médiatrice des petits côtés du rectangle (symétrie par rapport à une ligne s'étendant selon la hauteur des pixels). La forme F est ainsi bornée en hauteur par deux côtés a et b, le côté a plus petit que le côté b ; et elle est bornée en largeur par deux côtés latéraux inclinés c et d de part et d'autre de la médiatrice des bords haut l et bas l' de la forme rectangle. Dans chaque paire, l'orientation de la forme F de la partie de détection est inversée entre les deux pixels de détection : pour l'un, le plus petit côté a de la figure est en bas, pour l'autre ce plus petit côté a est en haut. Les parties masquées de la surface photosensible des pixels de détection sont figurées en hachuré sur la figure 4. Ce sont les deux parties notées m et m' pour le pixel P₁ et m" et m''' pour le pixel P₂

De préférence, et comme illustré, la figure complète d'une paire de détection incluant les deux parties masquées et la partie photosensible utile des deux pixels de la paire présente une symétrie centrale par rapport au point milieu entre les deux centres des pixels de chaque paire. Ce point milieu est celui noté O_{L} pour la paire PP_{L} et O_{R} pour la paire notée PP_{R}.

Dans l'exemple, la figure complète du pixel P_{N-1} de la paire PP_{L} correspond à celle du pixel P₂ de la paire PP_{G}; et celle du pixel P_{N}, correspond à celle du pixel P₁. On pourrait aussi bien faire correspondre (en formes) les pixels P₁ et P_{N-1}, et P₂ et P_{N}.

Ces aspects de conservation des formes et de symétrie facilitent la conception, la réalisation et l'utilisation des signaux de sortie des pixels de détection selon l'invention. Mais les dessins pourraient être différents sans que cela change le principe et les effets de l'invention. Il faut seulement pouvoir détecter un flux lumineux de petite taille sur toute la hauteur des pixels de détection avec une dissymétrie de réponse dans chaque paire, en faisant varier la largeur de la surface photosensible utile permettant la détection de flux lumineux, de façon monotone sur cette hauteur, mais dans un sens inverse pour les deux pixels de détection de la même paire.

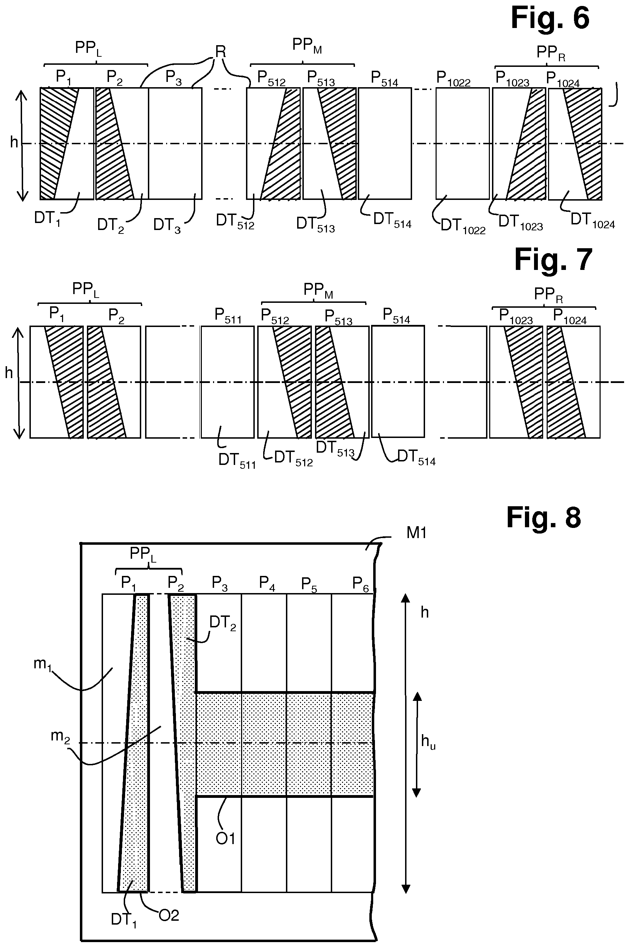

Dans l'exemple illustré, toute la hauteur h de surface photosensible de forme rectangle des pixels de prise d'image sert à la détection de rayonnement lumineux. Mais dans la pratique, la hauteur utile de détection des pixels de prise d'image peut être plus petite, selon les indications des cahiers des charges des appareils OCT. On fait cet ajustement en masquant optiquement, de manière symétrique, une bande en haut et une bande en bas du rectangle R, comme illustré sur la figure 8.

On peut utiliser avantageusement le même niveau de masque pour réduire la fenêtre de détection photosensible des pixels de prise d'image, et également délimiter la surface photosensible utile des pixels de détection. Dans l'exemple de la figure 8, les ouvertures O1, O2 réalisées dans le masque (un niveau de métal opaque (aluminium) au dessus du niveau de surface active du substrat semi-conducteur), délimitent les différentes surfaces photosensibles utiles permettant la détection de lumière (motif pointillé) par les pixels de détection et les pixels de prise d'image. Ces zones ouvertes optiquement par les ouvertures O1 et O2 du masque sont en pointillé sur la figure. Dans l'exemple, le dessin des ouvertures O1 et O2 est tel que les surfaces photosensibles utiles DT₁ DT₂ des pixels de détection s'étendent sur la hauteur complète h de rectangle R, pour garder une large fenêtre de détection en hauteur. Mais on peut préférer uniformiser la hauteur utile de détection photosensible sur l'ensemble des pixels de détection d'alignement et de prise d'image ; ceci peut faciliter les calculs d'interpolation sur les signaux fournis par les pixels de détection d'alignement, pour pouvoir utiliser ces signaux, avec ceux fournis par les pixels de prise d'image, pour la reconstruction d'image.

Le mode de réalisation présenté à la figure 4 a un inconvénient : la présence du masque optique sur chaque bord de la surface initiale photosensible de forme rectangle, peut perturber la génération et accumulation des charges dans le pixel de prise d'image adjacent à un pixel de détection. Dans l'exemple, les pixels de prise d'image concernés sont les pixels P3 et P_{N-2} et la réponse de ces pixels peut être dégradée (problème de diaphonie). Cet effet ne se retrouvant pas sur les autres pixels de prise d'image, on n'a plus d'uniformité de réponse sur l'ensemble des pixels de prise d'image, ce qui peut dégrader la qualité des images obtenues.

On note à ce propos que le choix de placer les deux paires de détection chacune à une extrémité de la ligne de pixels, a l'avantage de limiter ces effets de bord dû au masquage, à un seul pixel de prise d'image.

La figure 5 propose un autre exemple de réalisation, qui a l'avantage de limiter les effets de bord dans les pixels de prise d'image dus à la délimitation par masque optique dans les pixels de détection d'alignement.

Dans ce mode, la surface rectangle R d'un pixel de détection est alors divisée en deux parties : une partie photosensible utile qui permet la détection et une partie masquée, qui en est empêchée. Au moins dans les pixels de détection qui sont adjacents sur un côté à un pixel de prise d'image la partie utile de détection est placée du côté adjacent au pixel de prise d'image.

Dans l'exemple, les formes respectives de la partie masquée et la partie photosensible de détection sont identiques dans tous les pixels de détection. Ce qui change c'est leur orientation. Notamment la partie de détection des pixels de détection d'alignement a une forme F' identique pour tous les pixels de détection, comprise dans la forme rectangle R. Cette forme F' s'étend sur la hauteur h du rectangle entre les petits côtés l et l' de la forme rectangle R ; et un côté latéral de cette forme F' correspond à un grand côté de la forme rectangle. La forme F' est ainsi bornée en hauteur par deux côtés a' et b', le côté a' plus petit que le côté b' ; elle est bornée en largeur par un côté latéral incliné c' et un côté latéral droit d' qui correspond à un grand côté du rectangle R. Dans chaque paire, l'orientation de la forme F' de la partie de détection est inversée entre les deux pixels de détection : pour l'un, le plus petit côté a' de la figure est en bas, pour l'autre ce plus petit côté a' est en haut.

Dans le mode de réalisation illustré, les parties de détection sont placées du même côté de la surface rectangle pour les pixels de détection d'une même paire : à droite pour les pixels de la paire PP_{L} la plus à gauche ; à gauche pour les pixels de la paire PP_{R} la plus à droite. Et la figure complète incluant les parties masquées et de détection des pixels des deux paires PP_{L} et PP_{R} présente une symétrie axiale par rapport à l'axe BB. Cela pourrait être différent ; par exemple le pixel P_{N-1} pourrait avoir la figure complète du pixel P_{N} (et le pixel P_{N} celle du pixel P_{N-1}), sans incidence sur le principe de détection d'alignement selon l'invention.

Dans cette configuration, au sein de chaque paire, un pixel de détection (P₂ ou P_{N-}1) subit des effets de bord dus à la partie masquée du pixel lui-même ; pour l'autre pixel de détection (P₁ ou P_{N}), ces effets sont dus à la partie masquée du pixel lui-même et à celle de l'autre pixel de détection de la paire. On peut donc avoir une dissymétrie de comportement des pixels de détection de la paire. Notamment lorsque la ligne d'image est bien alignée au centre (situation③, Figure 3) la différence ΔS entre leurs signaux de sortie pourra ne pas être nulle. On note cependant que l'écart reste déterministe et peut être intégré dans les traitements numériques par le calculateur de l'appareil OCT.

Mais une autre disposition des parties de détection et masquées dans les paires permet d'éviter cela : on peut en effet disposer côte-côte, les parties masquées des pixels de détection d'une même paire, comme expliqué ci-après en relation avec la figure 7. Dans ce cas la partie de surface photosensible utile du pixel de détection est disposée dans la forme rectangle R du côté adjacent au pixel de prise d'image, et ce dernier ne voit plus le masque du pixel de détection.

Les figures 6 et 7 illustrent une variante de l'invention prévue pour le cas où la ligne lumineuse projetée par le spectromètre de l'appareil OCT n'est pas rectiligne, par exemple en forme de demi-sinusoïde avec une amplitude maximale sensiblement au milieu.

La ligne de pixels comprend alors au moins une troisième paire de pixels de détection selon l'invention qui est disposée sensiblement au milieu de la ligne de pixels. Dans l'exemple illustré sur les figures 6 et 7 d'une ligne de pixels comportant N=1024 pixels, cette troisième paire est formée avec les pixels P₅₁₂ et P₅₁₃ Dans cet exemple, la ligne d'image sera alors alignée quand elle sera du même côté par rapport à l'axe central AA aux deux extrémités, et de l'autre côté au milieu.

Sur la figure 6, les trois paires de détection sont obtenues de la même façon que sur la figure 5: la surface photosensible de chaque pixel est divisée en deux parties, l'une masquée et l'autre non, qui sert à la détection d'alignement, et la partie masquée est située du même côté dans les deux pixels de détection d'une même paire. Cette configuration n'est pas la plus optimale en ce qui concerne les effets de bord dus au masquage optique dans les pixels de détection de la paire PP_{M} en milieu de ligne : dans l'exemple, la partie masquée dans le pixel P₅₁₃ de la paire PP_{M} est du côté adjacent à un pixel de prise d'image (P₅₁₄).

La figure 7 propose une variante de cette configuration dans laquelle les parties masquées des deux pixels de détection de la paire centrale sont disposées côte-côte. On n'a plus d'effet de bord pour les pixels de prise d'image. Par exemple, si on regarde sur la figure les pixels de prise d'image P₅₁₁ et P₅₁₄ qui entourent les pixels P₅₁₂ et P₅₁₃ de la paire PP_{M} : les zones de détection DT₅₁₁ et DT₅₁₄ ne sont pas impactées par le masque délimitant les zones de détection DT₅₁₂ et DT₅₁₃ de la paire PP_{M}. Et dans chacune des zones de détection DT₅₁₂ et DT₅₁₃ on a un effet de bord que sur un seul côté. Cette disposition est avantageusement utilisée dans chacune des paires de détection de la ligne : on obtient une configuration optimale en ce qui concerne les possibles effets de bord, tant pour les pixels de prise d'image que pour les pixels de détection.

Dans tous les cas, comme déjà indiqué, les sorties des pixels de détection peuvent être également utilisées en opérationnel, avec les sorties des pixels de prise d'image, pour la reconstruction des images OCT, moyennant des calculs d'interpolation pour compenser les différences de surface utile de détection entre les pixels de détection d'alignement et les pixels de prise d'image et compenser les effets de bord éventuels dû au masquage optique.

En pratique, la partie photosensible délimitée des pixels de détection pourra avoir une surface qui correspond à environ la moitié de la surface rectangle photosensible des pixels de prise d'image, ou de préférence un peu plus de la moitié. Mais le rapport pourrait aussi bien être différent, plus petit, ou plus grand. Dans les pixels de prise d'image, la hauteur utile de détection peut être réduite jusqu'à une valeur égale à deux ou trois fois la taille de l'information lumineuse (largeur e de ligne d'image) à capturer.

Il est possible de délimiter les parties de surface photosensible permettant la détection d'un rayonnement lumineux dans les pixels de détection d'alignement, sans masquage optique.

Dans les réalisations précédentes, on réalisait dans un substrat semi-conducteur les N pixels de la ligne de manière identique, et notamment avec une même surface photosensible de forme rectangle ; on particularisait ensuite les pixels de détection parmi ces N pixels, au moyen d'un masquage optique.

On propose ici de particulariser directement, dans le semi-conducteur, les pixels de détection, c'est-à-dire la surface photosensible du pixel de détection a directement la forme voulue (F ou F'). Elle définit directement la surface photosensible utile, différente de la forme rectangulaire R des surfaces photosensibles utiles des pixels de prise d'image, en conservant le pas des pixels. Dans chaque pixel de détection d'alignement on réalise ainsi directement, par des implantations différenciées (dopages opposés) la partie photosensible utile qui permet la détection d'un rayonnement lumineux, et la ou les parties qui ne doivent pas permettre de détection, et la somme des surfaces de ces parties égale la surface photosensible (rectangle R) des pixels de prise d'image. Ce mode de réalisation est moins efficace en termes de réponse des pixels de détection, mais offre une alternative intéressante au masquage optique.

Plus précisément, lorsque l'on réalise une ligne de pixels, les pixels sont isolés les uns des autres par implantation, et la région d'implantation isolante entoure la partie photosensible utile (et aussi les régions actives des éléments de commande) de chaque pixel.

Ce que l'on propose, c'est de modifier le dessin des masques d'implantation, pour qu'à l'endroit des pixels de détection, la région active photosensible ait directement la forme voulue dans le plan de surface, avec une largeur qui varie sur la hauteur du pixel ; cette forme peut être l'une quelconque des formes illustrées aux figures 4 à 6 ; et cette forme est entourée par la région isolante, qui ne permet pas la détection d'un rayonnement lumineux. Dans un exemple la partie photosensible utile des pixels est une région de photodiode dopée de type N ; et la région d'isolation est une région dopée de type P qui ne peut pas accumuler de charges photogénérées. La région de photodiode dopée de type N peut comprendre en surface une couche superficielle fortement dopée de type P et portée au potentiel de référence du substrat.

Si on prend par exemple les pixels de détection P₁ et P₂ représentés sur la figure 8, les zones en pointillé DT₁ et DT₂ qui représentent les zones permettant la détection d'un rayonnement lumineux dans ces pixels seront alors des régions dopée N. Et les zones "blanches" m₁ et m₂ de ces pixels seront des régions fortement dopées P. Dans les pixels de prise d'image, toute la zone photosensible (rectangle R) de ces pixels sera une région dopée N. Comme il a déjà été expliqué supra, on pourra ensuite définir une hauteur utile hᵤ de détection dans les pixels de prise d'image (et éventuellement aussi celle des pixels de détection d'alignement) par masquage optique, indépendamment du fait que les pixels de détection d'alignement sont définis par implantation ou par masquage optique.

L'invention a été décrite en prenant en exemple un capteur linéaire dont les pixels de la ligne photosensible sont régulièrement espacés. La distance centre à centre est égale à p, le pas ("pitch") du réseau. L'invention ne se limite pas à cette configuration. En effet, on pourrait avoir une ligne de pixels avec un pas variable entre les pixels, pour correspondre à un étalement spectral déterminé du spectromètre, permettant la détection de longueurs d'onde déterminées (correspondance position du pixel, longueur d'onde).

## Revendications

1. Capteur linéaire comportant une ligne de N pixels (100) formés dans un substrat semi-conducteur, et un circuit de lecture des N pixels, délivrant un signal de sortie pour chacun des N pixels de la ligne, les N pixels comprenant des pixels de prise d'image qui présentent une surface photosensible utile de pixel pouvant recevoir des photons et les transformer en charges électriques, qui est de forme plus haute que large, où la largeur est dans la direction de la ligne et la hauteur dans la direction perpendiculaire, et au moins deux paires distantes de pixels de détection d'alignement (PP_{L}, PP_{G}), où les pixels de détection de chaque paire sont des pixels adjacents dans la ligne de pixels et ont une surface photosensible utile dont la largeur varie de façon monotone dans le sens de la hauteur, mais en sens contraire pour les deux pixels de détection d'une même paire,
**caractérisé en ce que** la forme est une forme rectangle.

2. Capteur linéaire selon la revendication 1, dans lequel une première paire (PP_{L}) est formée par les deux premiers pixels (P₁, P₂) de la ligne, et une deuxième paire (PP_{G}) est formée par les deux derniers pixels (P_{N-1}, P_{N}) de la ligne.

3. Capteur selon la revendication 2, comprenant une troisième paire de pixels de détection (PP_{M}) au voisinage du centre de la ligne de pixels.

4. Capteur selon l'une des revendications 1 à 3, **caractérisé en ce que** les pixels ont une constitution physique identique pour tous les N pixels, avec une même surface photosensible de forme rectangle (R), et un masque optique définit la surface photosensible utile des pixels de détection d'alignement.

5. Capteur selon l'une des revendications 1 à 4, **caractérisé en ce que** les pixels ont une constitution physique identique pour tous les N pixels, avec une même surface photosensible de forme rectangle (R), et un masque optique définit la surface photosensible utile des pixels de prise d'image.

6. Capteur selon l'une des revendications 1 à 3, **caractérisé en ce que** la forme (F) de la surface photosensible utile des pixels de détection d'alignement est délimitée par implantation.

7. Capteur selon l'une des revendications 1 à 6, **caractérisé en ce que** la forme de la surface photosensible utile des pixels de détection d'image présente une symétrie axiale par rapport à une ligne dirigée selon la hauteur des pixels.

8. Capteur selon l'une des revendications 4 et 5, **caractérisé en ce que** la surface photosensible utile des pixels de détection d'une paire forme une figure (F') dans la forme rectangle (R) de surface photosensible des pixels de prise d'image, qui s'étend sur la hauteur (h) de la forme rectangle (R) des surfaces photosensibles de prise d'image et dont un côté correspond à un grand côté (L, L') de la forme rectangle.

9. Capteur selon la revendication 7, **caractérisé en ce que** la surface photosensible utile d'un pixel de détection (P₂, P₅₁₂, P₅₁₃) est disposée dans ladite forme rectangle du côté adjacent à un pixel de prise d'image.

10. Caméra pour appareil d'imagerie de tomographie par cohérence optique dans le domaine de Fourier, **caractérisée en ce qu'**elle comporte un capteur linéaire selon l'une quelconque des revendications précédentes, fournissant une information d'alignement d'un trait lumineux qui est l'image spectrale formée par le spectromètre dans le plan de surface photosensible du capteur, sur la ligne de pixels de prise d'image du capteur.

## Patentansprüche

1. Linearer Sensor, umfassend eine Zeile mit N Pixeln (100), welche in einem Halbleitersubstrat gebildet sind, und einen Schaltkreis zum Auslesen der N Pixeln, welcher ein Ausgangssignal für jeden der N Pixel der Zeile abgibt, wobei die N Pixel Bildaufnahmepixel umfassen, welche eine lichtempfindliche Pixel-Nutzoberfläche aufweisen, welche in der Lage ist, Photonen aufzunehmen und diese in elektrische Ladungen umzuwandeln, welche eine Form mit größerer Höhe als Breite aufweist, wobei die Breite in der Zeilenrichtung liegt und die Höhe in der rechtwinkligen Richtung, und mindestens zwei beabstandete Paare von Fluchterkennungspixeln (PP_{L}, PP_{G}), wobei die Erkennungspixel eines jeden Paares angrenzende Pixel in der Pixelzeile sind und eine lichtempfindliche Nutzoberfläche aufweisen, deren Breite monoton in Richtung der Höhe, jedoch entgegengesetzt bei den beiden Erkennungspixeln desselben Paares variiert, **dadurch gekennzeichnet, dass** die Form eine Rechteckform ist.

2. Linearer Sensor nach Anspruch 1, wobei ein erstes Paar (PP_{L}) aus den beiden ersten Pixeln (P₁, P₂) der Zeile gebildet ist, und ein zweites Paar (PP_{G}) aus den beiden letzten Pixeln (P_{N-1}, P_{N}) der Zeile gebildet ist.

3. Sensor nach Anspruch 2, umfassend ein drittes Paar Erkennungspixel (PP_{M}) in der Nachbarschaft des Mittelpunktes der Pixelzeile.

4. Sensor nach einem der Ansprüche 1 bis 3, **dadurch gekennzeichnet, dass** die Pixel einen identischen physischen Aufbau für alle N Pixel aufweisen, mit einer gleichen lichtempfindlichen Oberfläche mit Rechteckform (R), und eine optische Maske die lichtempfindliche Nutzoberfläche der Fluchterkennungspixel definiert.

5. Sensor nach einem der Ansprüche 1 bis 4, **dadurch gekennzeichnet, dass** die Pixel einen identischen physischen Aufbau für alle N Pixel aufweisen, mit einer gleichen lichtempfindlichen Oberfläche mit Rechteckform (R), und eine optische Maske die Nutzoberfläche der Bildaufnahmepixel definiert.

6. Sensor nach einem der Ansprüche 1 bis 3, **dadurch gekennzeichnet, dass** die Form (F) der lichtempfindlichen Nutzoberfläche der Fluchterkennungspixel durch Implantation abgegrenzt ist.

7. Sensor nach einem der Ansprüche 1 bis 6, **dadurch gekennzeichnet, dass** die Form der lichtempfindlichen Nutzoberfläche der Bildaufnahmepixel eine Achsensymmetrie in Bezug auf eine Linie aufweist, welche entlang der Höhe der Pixel gerichtet ist.

8. Sensor nach einem der Ansprüche 4 und 5, **dadurch gekennzeichnet, dass** die lichtempfindliche Nutzoberfläche der Erkennungspixel eines Paares eine Figur (F') in der Rechteckform (R) der lichtempfindlichen Oberfläche der Bildaufnahmepixel bildet, welche sich über die Höhe (h) der Rechteckform (R) der lichtempfindlichen Bildaufnahmeoberflächen erstreckt, und wobei eine Seite davon einer langen Seite (L, L') der Rechteckform entspricht.

9. Sensor nach Anspruch 7, **dadurch gekennzeichnet, dass** die lichtempfindliche Nutzoberfläche eines Erkennungspixels (P₂, P₅₁₂, P₅₁₃) in der Rechteckform an der an einen Bildaufnahmepixel angrenzenden Seite angeordnet ist.

10. Kamera für optisches kohärenztomografisches Bildgebungsgerät im Fourier-Bereich, **dadurch gekennzeichnet, dass** sie einen linearen Sensor nach einem der vorhergehenden Ansprüche umfasst, welcher eine Ausfluchtungsinformation zu einem Lichtstrich bietet, welcher das spektrale Bild ist, welches durch das Spektrometer in der Ebene der lichtempfindlichen Oberfläche des Sensors auf der Bildaufnahme-Pixelzeile des Sensors gebildet wird.

## Claims

1. A linear sensor including a row (100) of N pixels that are formed in a semiconductor substrate, and a circuit for reading out the N pixels, which delivers an output signal for each of the N pixels of the row, the N pixels comprising image-capturing pixels that have a useful pixel photosensitive area able to receive photons and convert them into electric charge, which is in the shape that is higher than it is wide, where the width is in the direction of the row and the height is in the perpendicular direction, and at least two spaced-apart pairs of alignment-detecting pixels (PP_{L}, PP_{G}), wherein the detecting pixels of each pair are pixels that are adjacent in the row of pixels and that have a useful photosensitive area the width of which varies monotonically in the height direction, but in opposite directions for the two detecting pixels of a same pair, **characterized in that** the shape is in the shape of a rectangle.

2. The linear sensor as claimed in claim 1, wherein a first pair (PP_{L}) is formed by the first two pixels (P₁, P₂) of the row, and a second pair (PP_{G}) is formed by the last two pixels (P_{N-1}, P_{N}) of the row.

3. The sensor as claimed in claim 2, comprising a third pair of detecting pixels (PP_{M}) in the vicinity of the center of the row of pixels.

4. The sensor as claimed in one of claims 1 to 3, **characterized in that** all the N pixels have the same physical makeup and the same photosensitive area in the shape of a rectangle (R), and an optical mask defines the useful photosensitive area of the alignment-detecting pixels.

5. The sensor as claimed in one of claims 1 to 4, **characterized in that** all the N pixels have the same physical makeup and the same photosensitive area in the shape of a rectangle (R), and an optical mask defines the useful photosensitive area of the image-capturing pixels.

6. The sensor as claimed in one of claims 1 to 3, **characterized in that** the shape (F) of the useful photosensitive area of the alignment-detecting pixels is delineated by implantation.

7. The sensor as claimed in one of claims 1 to 6, **characterized in that** the shape of the useful photosensitive area of the image-detecting pixels has an axial symmetry with respect to a line directed along the height of the pixels.

8. The sensor as claimed in one of claims 4 and 5, **characterized in that** the useful photosensitive area of the detecting pixels of a pair forms a pattern (F') in the rectangle (R) of the photosensitive area of the image-capturing pixels, which extends over the height (h) of the rectangle (R) of the photosensitive image-capturing areas and one side of which corresponds to a long side (L, L') of the rectangle.

9. The sensor as claimed in claim 7, **characterized in that** the useful photosensitive area of a detecting pixel (P₂, P₅₁₂, P₅₁₃) is placed in said rectangle on the side adjacent to an image-capturing pixel.

10. A camera for a Fourier-domain optical coherence tomographic imaging apparatus, **characterized in that** it includes a linear sensor according to any one of the preceding claims, which delivers information on the alignment of a luminous strip, namely the spectral image formed by the spectrometer in the plane of the photosensitive area of the sensor, on the row of image-capturing pixels of the sensor.
